Europäisches Patentamt

European Patent Office

Office européen des brevets

(11) Publication number: **0 439 084 A2**

# EUROPEAN PATENT APPLICATION

(21) Application number: **91100649.2**

(22) Date of filing: **21.01.91**

(51) Int. Cl.⁵: **H01L 21/00**

(30) Priority: **23.01.90 JP 13312/90**

(43) Date of publication of application:
**31.07.91 Bulletin 91/31**

(84) Designated Contracting States:
**DE FR GB**

(71) Applicant: **Kabushiki Kaisha Toshiba**
**72, Horikawa-cho Saiwai-ku**
**Kawasaki-shi(JP)**

(72) Inventor: **Nakagawa, Kaoru, c/o Intellectual**
**Property Div.**
**Kabushiki Kaisha Toshiba, 1-1 Shibaura**
**1-chome**
**Minato-ku, Tokyo 105(JP)**
Inventor: **Tatumi, Yoshiaki, c/o Intellectual**
**Property Div.**

Kabushiki Kaisha Toshiba, 1-1 Shibaura
1-chome
Minato-ku, Tokyo 105(JP)
Inventor: **Hasegawa, Taiji c/o Intellectual**
**Property Div.**
**Kabushiki Kaisha Toshiba, 1-1 Shibaura**
**1-chome**
**Minato-ku, Tokyo 105(JP)**
Inventor: **Nakagiri, Minoru, c/o Intellectual**
**Property Div.**
**Kabushiki Kaisha Toshiba, 1-1 Shibaura**
**1-chome**
**Minato-ku, Tokyo 105(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) **Assembling system of semiconductor chip.**

(57) An assembling system of a semiconductor chip comprises a die bonding step, a wire bonding step, a molding step, a deflashing step, a lead cladding step, a marking step, a lead bending step, a testing step and a tape-wrapping step, which are arranged in the order mentioned. Each of the molding step, the deflashing step and the lead cladding step is performed by only a first treating apparatus (12, 13 or 14). Each of the die bonding step, the wire bonding step, the marking step, the lead bending step, the testing step and the taping step is performed by first and second treating apparatuses (10, 11, 15, 16, 17 or 18). The second treating apparatus is substantially equal in function to the first treating apparatus and arranged in parallel with the first treating apparatus so as to share the operation of each treating step. Where the second treating apparatuses are included in two adjacent treating steps, these two second treating apparatuses are connected in series. Where the first treating apparatus alone is included in the adjacent treating step, the second treating apparatus is connected to the first treating step.

F I G. 1

## ASSEMBLING SYSTEM OF SEMICONDUCTOR CHIP

The present invention relates to an assembling system of a semiconductor chip, more particularly, to an assembling system in which the entire assembling process starting with the die bonding step of a semiconductor chip and ending in the taping step for the wrapping is carried out in an integral machine.

A semiconductor chip is prepared by forming at least one element selected from circuit components including active elements, passive elements, resistors, etc. in a semiconductor substrate. In many cases, a lead frame is used for assembling the semiconductor chip. In general, the assembling process includes the steps of die bonding, wire bonding, resin encapsulation by means of transfer molding method, deflashing, lead cladding, marking, lead bending, testing and taping for wrapping.

In the conventional assembling process, a semiconductor chip is mounted to a lead frame and, after subsequent bonding steps, encapsulated with resin using a molding apparatus. Thin burrs generated in the encapsulating step are removed by a deflashing apparatus. In the subsequent lead cladding step, a plating or soldering is applied to an outer lead formed of Fe, Fe-Ni alloy, Cu or Cu alloy and leading from within the encapsulating resin layer to the outside. What should be noted is that each of the molding apparatus, the deflashing apparatus and the lead cladding apparatus used in the conventional assembling process of a semiconductor chip is bulky and costly.

In order to improve the assembling process comprising the various steps noted above, proposed is a system in which the apparatuses for these various steps are joined to each other so as to provide an integral machine. These apparatuses are joined to each other in the order of, for example, a die bonder, a wire bonder, a molding apparatus, a deflashing apparatus, a lead cladding apparatus, a marking apparatus, a lead bending apparatus, a tester, and a taping apparatus, and a buffer function is provided between the adjacent apparatuses.

A thermosetting resin is used for the resin encapsulation. Since several minutes are required for a cycle of the softening, sealing into a mold, and setting of the thermosetting resin, a batch treatment is applied to a plurality of lead frames each having a semiconductor chip mounted therein. Further, an average treating speed tends to be lowered depending on the number of test items in a tester and by the replacement of a carrier tape in a taping apparatus. It follows that, if the apparatuses used in the individual steps of the assembling process are simply joined to each other, serious problems are brought about, as summarized below:

1. The assembling rate of the entire system is determined by the efficiency of the apparatus having the longest treating time and the lowest treating capacity.

2. The molding apparatus and the lead cladding apparatus are superior to the marking apparatus, the die bonder, the tester and the taping apparatus in the treating capability, but are very costly. Thus, the entire system is rendered uneconomical unless the molding apparatus and the lead cladding apparatus are enabled to exhibit the full treating capabilities.

3. Even if a plurality of die bonders, wire bonders, etc., whose treating speed is low, are arranged in parallel in an attempt to improve the treating speed of the entire system, it is impossible to treat semiconductor chips of different kinds in parallel because the different kinds of the semiconductor chips are mixed with each other.

The present invention has been achieved in view of the situation described above and is intended to provide an assembling system of a semiconductor chip, in which all the assembling steps starting with the die bonding step and ending in the taping step are rationally joined to each other so as to achieve the assembling operation economically and efficiently.

It is important to note that some of a series of first treating apparatuses for performing the series-connected assembling steps are low in the treating speed, and the others are high in the treating speed, with the result that the treating speed of the assembling system is determined by the treating speed of the apparatus having a low treating speed. To overcome the difficulty, at least one second treating apparatus is included in the system so as to assist the treating operation of the first apparatus having a low treating speed.

According to one embodiment of the present invention, there is provided an assembling system of a semiconductor chip for performing series-connected steps of die bonding, wire bonding, molding, deflashing, lead cladding, marking, and testing, comprising:

a series of first treating apparatuses for performing the series-connected treating steps; and

at least one second treating apparatus connected in parallel with one of the first treating apparatuses having a treating speed lower than that of the other first treating apparatuses so as to bear a part of the operation of the corresponding step, said second treating apparatus being substantially equal in function to the first treating apparatus whose treating speed is low;

wherein, where said second treating apparatuses are included in two adjacent treating steps, the second treating apparatus in a certain treating step is connected in series to only the second treating apparatus included in the succeeding treating step, and where the first treating apparatus alone is included in the succeeding treating step, the second treating apparatus in a certain treating step is connected to the first treating apparatus of the succeeding treating step.

The assembling system of the present invention may further comprise a lead bending step and a tape-wrapping step.

In a preferred embodiment of the present invention, each of the molding step, deflashing step, and lead cladding step are substantially performed by only the first treating apparatus, and each of the die bonding step, wire bonding step, marking step, lead bending step, testing step and tape-wrapping step are performed by the first and second treating apparatuses.

In another preferred embodiment of the present invention, a buffer means is provided between two adjacent steps for controlling the timing of supplying a semiconductor chip to the succeeding step. Also, a robot means for classifying semiconductor chips of different kinds is provided between the step including the first treating apparatus alone and the step including the first and second treating apparatuses. The assembling system of the present invention further comprises a sensor means for detecting a discrimination mark formed in the sealing resin layer of the semiconductor chip such that said sensor means co-operates with said robot means.

In the semiconductor chip assembling system of the present invention, the apparatuses having a low treating speed are connected in parallel in each treating step so as to make the treating capability in each step uniform. The particular technique of the present invention produces prominent effects as summarized below:

(A) In the conventional system, workpieces are treated in a unit of lot. However, a single article can be treated in the system of the present invention.

(B) The system of the present invention permits saving the labor by about 80%, compared with the conventional system.

(C) The system of the present invention permits reducing the facility cost to about 90% of the level for the conventional system in the small or middle scale of production, i.e., less than about 6,000,000 articles per month.

(D) The system of the present invention permits shortening the lead time. In the conventional batch treating system, the treating time in a single step is long because a large number of lots are involved in the system. In the present invention, however, the workpiece can be treated with a predetermined treating speed without fail, making it possible to shorten the treating time to about 10%.

(E) The system of the present invention permits improving the quality of the treated article. Specifically, an automatic treatment is carried out in almost all the treating steps in the present invention, with the result that it is impossible for a treating step to be inadvertently omitted. It is also possible to suppress variation in the treating time in each step. It follows that the treated articles are made uniform in quality. It should be noted in this connection that, if lots are collected before the marking step, it is difficult to distinguish the different kinds of the workpieces in the conventional batch treating system. Thus, different kinds of treated articles tend to be mixed in the conventional system.

(F) In the system of the present invention, workpieces are orderly transferred from the die bonding step until the tape-wrapping step. Thus, the tape-wrapping can be applied efficiently even to an article which necessitates a pair such as a variable capacitance diode.

This invention can be more fully understood from the following detailed description when taken in conjunction with the accompanying drawings, in which:

Fig. 1 schematically shows an assembling system according to one embodiment of the present invention;

Fig. 2 shows a casing of a semiconductor chip, which is marked or not marked; and

Figs. 3 and 4 schematically show assembling systems according to modifications of the present invention.

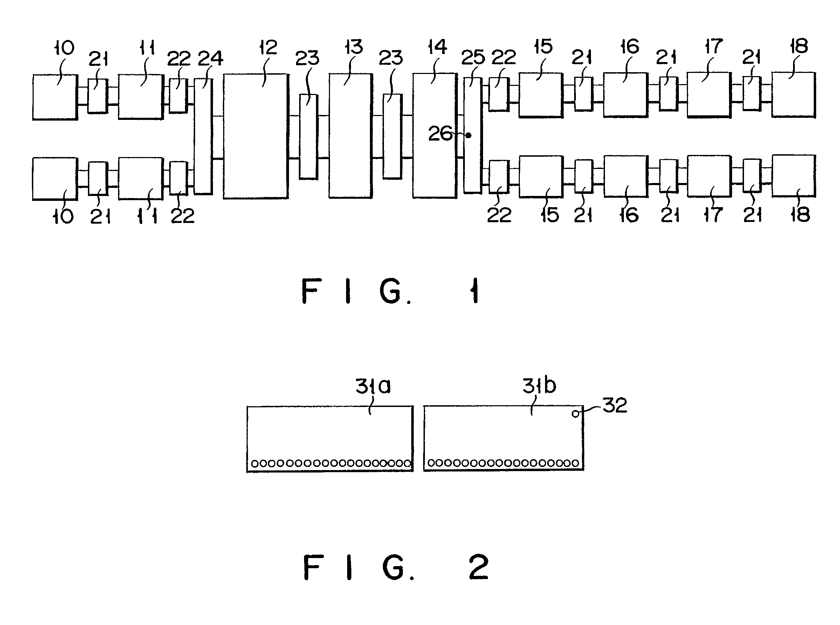

An assembling system according to one embodiment of the present invention is schematically shown in Fig. 1. As seen from the drawing, the assembling system comprises a die bonder 10, a wire bonder 11, a molding apparatus 12, a deflashing apparatus 13, a lead cladding apparatus 14, a marking apparatus 15, a lead bending apparatus 16, a tester 17 and a taping apparatus 18, which are connected in series in the order mentioned.

In the system shown in Fig. 1, the treating speed of each of the molding apparatus 12, the deflashing apparatus 13 and the lead cladding apparatus 14 is about twice the treating speed of each of the die bonder 10, the wire bonder 11, the making apparatus 15, the lead bending apparatus 16, the tester 17 and the taping apparatus 18. Also, the apparatuses 12, 13 and 14 are generally expensive and bulky as widely known in this technical field. Naturally, large spaces are required for these apparatuses. Thus, in this embodiment, the molding apparatus 12, the deflashing apparatus 13 and the lead cladding apparatus 14 are arranged to form a single line of treatment. On the other hand, a pair of die bonders 10 and a pair of wire bonders 11 are arranged upstream of the molding apparatus 12 such that these die bonders 10 and the wire bonders 11 form two parallel lines of treatment. Likewise, a pair of marking apparatuses 15, a pair of lead bending apparatuses 15, a pair of testers 17 and a pair of taping apparatuses 18 are arranged downstream of the lead cladding apparatus 14 such that these apparatuses 15, 16, 17 and 18 form two parallel lines of treatment.

Further, buffer members 21, 22 and 23 are provided between two adjacent treating apparatuses included in the assembling system. These buffer members serve to cope with an unexpected accident taking place in the treating apparatus and to make up for the difference in the treating speed between the adjacent treating apparatuses so as to control the timing of supplying the workpiece to the succeeding step.

A robot 24 is disposed between the wire bonder 11 and the molding apparatus 12. Where semiconductor chips of different kinds are treated in parallel by the parallel treating lines formed by the die bonders 10 and the wire bonders 11, the robot 24 serves to control, as required, the timing of supplying the different kinds of workpieces to the molding apparatus. Thus, the buffer member 22 positioned immediately before the robot 24 performs a storing function for controlling the amount of the semiconductor chips required for the succeeding treating step.

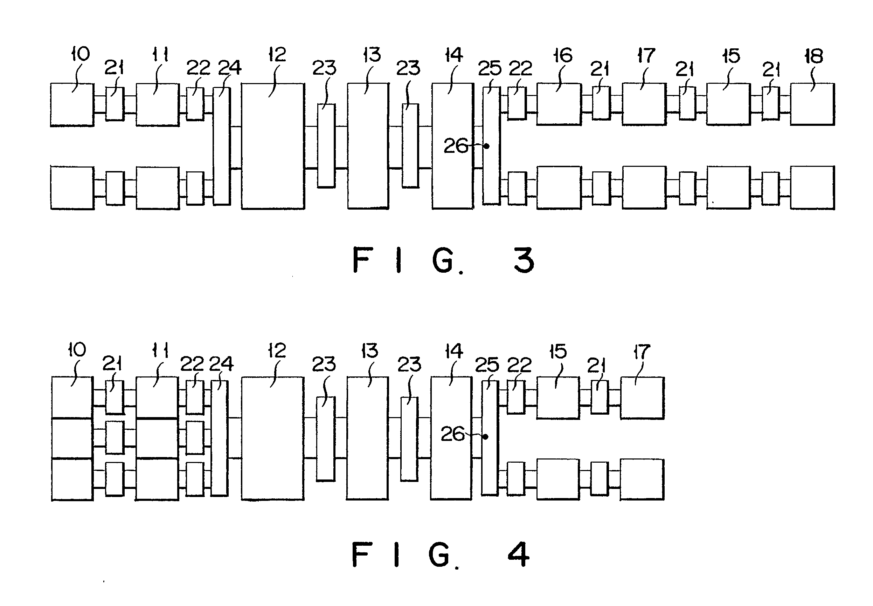

Likewise, a robot 25 is disposed between the lead cladding apparatus 14 and the marking apparatus 15. A discrimination mark 32 formed in the housing of a chip as shown in Fig. 2 is detected by a sensor 26 so as to enable the robot 25 to classify the semiconductor chips depending on the kind of the chip. The semiconductor chips thus classified are supplied to a pair of treating lines arranged in parallel, each treating line consisting of the marking apparatus 15, the lead bending apparatus 16, the tester 17 and the taping apparatus 18. The buffer member 22 positioned immediately after the robot 25 also performs a storing function so as to control the amount of the semiconductor chips required for the succeeding step.

In the assembling system of the present invention described above, it is possible to treat semiconductor chips of different kinds in parallel in a pair of parallel treating lines each consisting of the die bonder 10 and the wire bonder 11, followed by a continuous treatment in a single treating line consisting of the molding apparatus 12, the deflashing apparatus 13 and the lead cladding apparatus 14. Further, the chips of different kinds are treated in parallel in a pair of parallel treating lines each consisting of the marking apparatus 15, the lead bending apparatus 16, the tester 17 and the taping apparatus 18. In this case, however, it is necessary to take measures for preventing the chips of different kinds from being mixed with each other. To this end, utilized are discrimination marks put on the sealing resin layer acting as a housing of the chip so as to classify the chips depending on the kinds thereof. For example, a small circular hole acting as a discrimination mark 32 is made in a sealing resin layer 31b, but is not made in another sealing resin layer 31a, as shown in Fig. 2. It suffices for the mark 32 to differentiate semiconductor chips of two different kinds. Thus, a rectangular hole, a groove, a recess made in the corner, etc. may be used in place of the small circular hole as the discrimination mark 32. Incidentally, the molding apparatus comprises an inward projection or the like serving to form the discrimination mark 32 in the sealing resin layer.

Figs. 3 and 4 show modifications of the assembling system of the present invention. Throughout Figs. 1, 3 and 4, the like reference numerals denote the like members of the system.

The modification shown in Fig. 3 is substantially equal to the system shown in Fig. 1, except that, in Fig. 3, the marking apparatus 15 is positioned downstream of the lead bending apparatus 16 and the tester 17. The modification shown in Fig. 4 is also substantially equal to the system shown in Fig. 1, except that, in Fig. 4, the die bonders 10 and the wire bonders 11, which are generally low in the treating speed, are arranged to form three parallel treating lines. Also, since the lead wire is not bent in the step of dicing the semiconductor chips, the lead bending apparatus 16 is not included in the system shown in Fig. 4. Further, a wrapping treatment other than taping is employed in the modification shown in Fig. 4 and thus, the taping apparatus 18 is omitted from the assembling system. Needless to say, it is possible to change the number of parallel treating lines, as desired, depending on the treating speed of the apparatus included in the system.

**Claims**

1. An assembling system of a semiconductor chip for performing series-connected steps of die bonding, wire bonding, molding, deflashing, lead cladding, marking, and testing, comprising:

   a series of first treating apparatuses (10, 11, 12, 13, 14, 15 and 17) for performing the series-connected treating steps; and

at least one second treating apparatus (10, 11, 15 or 17) connected in parallel with one of the first treating apparatuses (10, 11, 15 or 17) having a treating speed lower than that of the other first treating apparatuses (12, 13 and 14) so as to bear a part of the operation of the corresponding step, said second treating apparatus being substantially equal in function to the first treating apparatus whose treating speed is low;

characterized in that, where said second treating apparatuses are included in two adjacent treating steps, the second treating apparatus in a certain treating step is connected in series to only the second treating apparatus included in the succeeding treating step, and where the first treating apparatus alone is included in the succeeding treating step, the second treating apparatus in a certain treating step is connected to the first treating apparatus of the succeeding treating step.

2. The system according to claim 1, characterized in that each of said molding step, deflashing step and lead cladding step is substantially performed by only said first treating apparatus (12, 13 or 14).

3. The system according to claim 2, characterized in that each of said die bonding step, wire bonding step, marking step and testing step is substantially performed by the first and second treating apparatuses (10, 11, 15 or 17).

4. The system according to claim 1, characterized in that buffer means (21, 22 and 23) serving to control the timing of supplying said semiconductor chip to the succeeding step is provided between two adjacent treating steps.

5. The system according to claim 4, characterized by further comprising robot means (25) serving to classify semiconductor chips of different kinds, said robot means being disposed between the step in which said first treating apparatus alone resides and the step in which said first and second treating apparatuses reside.

6. The system according to claim 5, characterized by further comprising sensor means (26) for detecting a discrimination mark (31) formed in a sealing resin layer of the semiconductor chip for co-operation with said robot means.

7. The system according to claim 3, characterized by further comprising a third treating apparatus (10 or 11) included in each of the die bonding step and the wire bonding step, said third treating apparatus being substantially equal in function to the first and second treating apparatuses (10 or 11) and arranged in parallel with the first and second treating apparatuses (10 or 11).

8. An assembling system of a semiconductor chip for performing series-connected steps of die bonding, wire bonding, molding, deflashing, lead cladding, marking, lead bending, testing and taping for wrapping, comprising:

a series of first treating apparatuses (10, 11, 12, 13, 14, 15, 16, 17 and 18) for performing the series-connected treating steps; and

at least one second treating apparatus (10, 11, 15, 16, 17 or 18) connected in parallel with one of the first treating apparatuses (10, 11, 15, 16, 17 or 18) having a treating speed lower than that of the other first treating apparatuses (12, 13 and 14) so as to bear a part of the operation of the corresponding step, said second treating apparatus being substantially equal in function to the first treating apparatus whose treating speed is low;

characterized in that, where said second treating apparatuses are included in two adjacent treating steps, the second treating apparatus in a certain treating step is connected in series to only the second treating apparatus included in the succeeding treating step, and where the first treating apparatus alone is included in the succeeding treating step, the second treating apparatus in a certain treating step is connected to the first treating apparatus of the succeeding treating step.

9. The system according to claim 8, characterized in that each of said molding step, deflashing step and lead cladding step is substantially performed by only said first treating apparatus (12, 13 or 14).

10. The system according to claim 9, characterized in that each of said die bonding step, wire bonding step, marking step, lead bending, testing step, and taping step is substantially performed by the first and second treating apparatuses (10, 11, 15, 16, 17 or 18).

11. The system according to claim 8, characterized in that buffer means (21, 22 and 23) serving to control the timing of supplying said semiconductor chip to the succeeding step is provided between two adjacent treating steps.

12. The system according to claim 10, characterized by further comprising robot means (25) serving to classify semiconductor chips of different kinds, said robot means being disposed between the step in which said first treating apparatus alone resides and the step in which said first and second treating apparatuses reside.

13. The system according to claim 10, characterized by further comprising sensor means (26) for detecting a discrimination mark (32) formed in a sealing resin layer of the semiconductor chip for co-operation with said robot means.

F I G. 1

F I G. 2

F I G. 3

F I G. 4